Europäisches Patentamt

European Patent Office

Office européen des brevets

(11) Publication number:

**0 295 816**

**A2**

## (12) EUROPEAN PATENT APPLICATION

(21) Application number: **88305111.2**

(22) Date of filing: **03.06.88**

(51) Int. Cl.⁴: **H05K 1/03 , H05K 3/46**

(30) Priority: **04.06.87 JP 140188/87**
**04.06.87 JP 140189/87**
**26.02.88 JP 43445/88**

(43) Date of publication of application:
**21.12.88 Bulletin 88/51**

(84) Designated Contracting States:
**DE FR GB**

(71) Applicant: **SHIN-KOBE ELECTRIC MACHINERY CO LTD**
**No. 1-1, Nishishinjuku 2-chome**
**Shinjuku-ku Tokyo(JP)**

(72) Inventor: **Kariya, Kenichi**
**No. 1964-11, Hassaka-cho**
**Hikone-shi Shiga-ken(JP)**
Inventor: **Noda, Masayuki**
**No.777-10, Kawasebaba-cho**
**Hikone-shi Shiga-ken(JP)**
Inventor: **Yamaguchi, Takahiro**
**c/o Seiwaryo No. 47, Kiyosaki-cho**
**Hikone-shi Shiga-ken(JP)**
Inventor: **Takahashi, Katsuji**
**c/o Seiwaryo No. 47, Kiyosaki-cho**
**Hikone-shi Shiga-ken(JP)**

(74) Representative: **Diamond, Bryan Clive et al**
**Gee & Co. Chancery House Chancery Lane**
**London WC2A 1QU(GB)**

(54) Resin-impregnated fabrics laminated to metal foil.

(57) A woven or nonwoven fabric made of a mixture of at least two of meta-aramid, polyethylene terephthalate and glass fibers is impregnated with a solution of an adduct of an epoxy resin and a copolymer of acrylonitrile and butadiene having carboxyl groups at both chaim ends; as a preliminary reaction product or mixed with another epoxy resin. A curing agent maybe included in the solution.

The dried impregnated fabric is dried and a metal foil, e.g. of copper, is placed over at least one face of the fabric base and is laminated thereto by heat and pressure.

The resultant laminate is usable as a printed circuit board and can be bent to a desired shape.

EP 0 295 816 A2

## RESIN-IMPREGNATED FABRICS LAMINATED TO METAL FOIL

This invention relates to a metal foil covered laminate suitable for use as a printed circuit board, for example.

There has been known a bendable sheet covered with metal foil, for use as a flexible printed circuit, comprising a film of polyimide or polyester and a metal foil covering the film. Although such a foil-covered sheet has a good characteristic of withstanding repeated bending, it has no reinforcing base, so that the sheet suffers a large shrinkage in size when heat is applied thereto. This disadvantageously limits the range of use thereof.

There has been also known a metal foil covered laminate comprising a sheet-like base of glass nonwoven fiber or paper impregnated with thermo-setting resin (such as epoxy resin or phenolic resin) and a metal foil thermally adhered to the sheet-like base. Although such a laminate is bendable if it is relatively thin it is not suitable for use in a bent condition because it would be easily damaged by bending it to an extreme extent such as more than 180°.

There has been proposed a metal foil covered laminate comprising a sheet-like base formed of nonwoven fibers of a mixture of glass fiber and polyester fiber impregnated with epoxy resin and a metal foil thermally adhered to the sheet-like base, as disclosed in Japanese Patent Application No. JP-A-184,587/1984. However, the laminate having conventional epoxy resin included therein is not suitable for use while bent. The type of epoxy resin to be used for providing a bendable laminate has not hitherto been known.

Electronic apparatus desirably has a minimal thickness and areal size which may require a printed circuit board contained therein to be bent so as to fit into a small space. However, there has not been known a printed circuit board having a good bending characteristic and a minimal shrinkage when heated, such as when metal components are soldered thereto.

Accordingly, it is a principal object of the invention to provide a metal foil covered laminate which has improved bending characteristics, minimal shrinkage when heated, and preferably also a high tensile strength and an excellent heat resistance to soft solder.

In accordance with the present invention there is provided a metal foil covered laminate comprising;

a sheet-like base formed of at least two of meta-aramid fibers, polyethylene terephthalate fibers and glass fibers and impregnated with an epoxy resin which includes an acrylonitrile/butadiene copolymer having carboxyl groups at its terminals;

and a metal foil covering on said shet-like base.

The sheet-like base may be formed of meta-aramid fiber and polyethylene terephthalate fiber, of meta-aramid fiber and glass fiber or of glass fiber and polythylene terephthalate fiber and the fiber may be woven or nonwoven.

An acrylonitrile/butadiene copolymer is a high nitrile copolymer having a content of acrylonitrile of preferably 10 to 20 weight %. The copolymer has carboxyl groups introduced into both ends of the main chain of the copolymer. It is esterfied with an epoxy resin having more than two oxirane (epoxy) groups to form a preliminary condensation material; such preliminary condensation material is used as it is or after it is blended with epoxy resin.

The epoxy resin including acrylonitrile/butadiene copolymer having carboxyl groups at its terminal possesses a good bending characteristic. As the amount of acrylonitrile included in the copolymer increases, its polarity is advantageously increased so that adhesion and softness are provided to the resin.

A curing agent may be added to the resin, and an organic solvent added to make a solution or "varnish" to impregnate the base.

Aramid fiber is a heat-resistant organic synthetic fiber having a major component of polymetaphenyleneisophthalamide which is formed of metaphenylene diamine and isophthalic acid chloride as major component. Aramid fiber has two bonding types, meta and para; the aramid fiber used in the invention is limited to the meta type because meta-aramid fiber has an insulation resistance higher than para-aramid fiber because the former is more easily moistened by the epoxy resin and meta-aramid fiber has a die-cutting capability better than that of aramid fiber.

The thermal shrinkage of aramid fiber at a temperature of 200°C is 0.5% while that of polyethylene terephthalate is 8%; thus aramid fiber is close to the characteristic of inorganic glass fiber. Thus, size shrinkage of the laminate can be prevented by inclusion of aramid fiber. Since a bent base is extended on its outer or convex face while it is compressed on the concave face, it is supposed that as the flexibility of the laminate base is better, it improves the bending characteristic. As regards the expansion ratio of various fibers, the expansion ratio of meta-aramid fiber is 35% while that of polyethylene terephthalate fiber is

2

better about 45%. Therefore they provide beter bending characteristic to the laminate base together with the epoxy resin.

When the sheet-like base is formed of a mixture of meta-aramid fiber and glass fiber, the laminate has a low size shrinkage and an excellent thermal resistance to soft solder; because the bending characteristic of the laminate base is improved by the higher elongation ratio of meta-aramid fiber relative to the elongation ratio of about 3% of glass fiber and also because the thermal shrinkage of both fibers is lower and the thermal resistance of both fibers is high. Aramid fiber alone is not used in the invention because it has lower die-cutting work capability and moisture-resistance.

When the base is formed of glass fiber and polythylene terephthalate fiber, the laminate has a good bending characteristic and low size shrinkage, because glass fiber has a dimensional stability to heat and polyethylene terephthalate fiber has a higher expansion ratio.

When the base is formed of woven fibers, the laminate has high tensile strength, because the tensile strength of the base of woven fiber is several times to ten and several times as much as that of the base of nonwovan fiber.

Thus this invention can accomplish the objects of good bending characteristic and prevention of size shrinkage by a combination of specific resin and base; and it can provide thermal resistance to soft solder and high tensile strength to the laminate.

With a sheet-like base of nonwoven meta-aramid fiber and polyethylene terephthalate fiber the ratio of the fibers is not defined, but as the ratio of polyethylene terephthalate fiber increases repeated bending and moisture-resistance will be much improved while the size shrinkage will be larger. Thus, the ratio of the fibers should be selected to obtain the desired properties with a woven fabric of meta-aramid fiber and polyethylene terephthalate fiber, the fibers may be woven after they are twisted together into one thread or they may be woven after they are separately twisted into threads.

In case of a laminate base of woven fabris, the proportion of 40 weight % of meta-aramid fiber gives better results. As the ratio of meta-aramid fiber increases, the die-cutting property of the base is reduced.

The metal foils, e.g. of copper, can be fixed to the base by applying heat and pressure.

The following Examples illustrate the invention.

In Examples 1 to 6, there were used a sheet-like base of meta-aramid fiber and polyethylene terephthalate fiber.

## Example 1

80 weight parts of an acrylonitrile/butadiene copolymer having carboxyl groups at both chain ends (tradname CTBN 1300 x 8, manufactured by Ube Kosan Company, Japan), 100 weight parts of epoxy resin (tradename EP-828, manufactured by Yuka Shell Company, Japan) and 0.26 weight parts of catalyst of triphenyl phosphine were admixed and reacted with each other at a temperature of 180°C for 4 hours to obtain a preliminary reactant. To this reactant was added a high polymeric epoxy resin (tradename EP-1009, manufactured by Yuka Shell Company, Japan) so that 10 weight % of acrylonitrile/butadiene copolymer was included in the resultant mixed resin, and it was blended with a novolak type phenol resin as curing agent to obtain a resin varnish.

A base material of meta-aramid fiber and polyethylene terephthalate fiber in the form of nonwoven cloth admixed so that the weight ratio of meta-aramid fiber to polyethylene terephthalate fiber was 1/5 was impregnated with the resultant resin varnish so that the resin was present as 80%. After this was dried to obtain a prepreg, copper foils having a thickness of 35 μm were placed on both faces of the prepreg and subject to a pressure of 30 kg/cm² at a temperature of 170°C for 30 minutes to provide a both face copper foil covered laminate of thickness of 0.2 mm.

## Example 2

A laminate was obtained by the process identical to the process for producing the laminate of Example 1 except that the base of meta-aramid fiber and polyethylene terephthalate fiber in the form of nonwoven cloth combined so that the weight ratio of meta-aramid fiber to polyethylene terephthalate fiber was 5/1 was used.

## Comparison 1

To an epoxy resin (tradename EP-1001, manufactured by Yuka Shell Company, Japan) was added the curing agent of dicyandiamide so that it was included by 4 weight %,to obtain a resin varnish. The nonwoven cloth base of Example 1 was impregnated with the resultant resin varnish so that the resin was included by 80 weight % and dried to obtain a prepreg. Copper foils of 35 μm were faced with the prepreg and thermally pressurized in the same manner as described on Example 1 to obtain a both face copper foil covered laminate of 0.2 mm thickness.

## Comparison 2

The prepreg was produced by impregnating a base of nonwoven glass fiber cloth with resin varnish used in Example 1 so that the resin was included as 80 weight % and drying it. A both face copper foil covered laminate of 0.2 mm thickness was produced by using the resultant prepreg in the same manner as described in Example 1.

## Comparison 3

A base of para-aramid fiber and polyethylene terephthalate fiber combined in the form of nonwoven cloth so that the weight ratio of para-aramid fiber to polyethylene terephthalate fiber was 1/5 was impregnated with the resin varnish used in Example 1 to produce a prepreg in the same manner as described in Example 1. A both face copper foil covered laminate of 0.2 mm thickness was produced by using the resultant prepreg in the same manner as described in Example 1.

## Comparison 4

A base of only meta-aramid nonwoven fiber cloth was used to produce a prepreg and a both face copper foil covered laminate of 0.2 mm thickness was produced by using the resultant prepreg in the same manner as described in Example 1.

## Prior Art 1

To both faces of a polyimide film (tradename Kapton,manufactured by DuPont) of 0.13 mm thickness was adhered copper foils of 35 μm.

## Prior art 2

A prepreg was produced by impregnating a base of nonwoven glass fiber cloth with resin varnish used in Comparison 1 so that the resin was included by 80 weight % and drying it. A both face copper foil covered laminate of 0.2 mm thickness was produced by using the resultant prepreg in the same manner as described in Example 1.

## Prior art 3

A paper base was impregnated with resol type phenol resin varnish so that the resin was included by 45 % and dried to obtain a prepreg. Copper foils of 35 μm were faced with the prepreg and subject to a pressure of 100 kg/cm² at a temperature of 170°C for 30 minutes to obtain a both face copper foil covered laminate of 0.2 mm thickness.

A table I indicates the result of characteristic tests of the laminates or sheets of Examples. Comparisons and Prior arts. In the table, "DCW" designates die-cutting work process, "RBD" designates 180 degree repeated bending characteristics "IR" designates insulation resistance (D-2/100) and "SRR" designates size shrinkage ratio (E-0.5/150).

### TABLE I

|  | DCW | RBD | IR | SSR (%) |
|---|---|---|---|---|
| Example 1 | ◯ | more than 10 times | $5 \times 10^{13}$ | 0.18 |
| Example 2 | ◯ | 8 times | $2 \times 10^{13}$ | 0.15 |
| Comparison 1 | ◯ | ✕ | $8 \times 10^{12}$ | 0.17 |
| Comparison 2 | ◯ | ✕ | $6 \times 10^{12}$ | 0.10 |
| Comparison 3 | ✕ | more than 10 times | $2 \times 10^{8}$ | 0.18 |
| Comparison 4 | △ | 2 times | $7 \times 10^{12}$ | 0.14 |
| Prior art 1 | △ | more than 10 times | $2 \times 10^{12}$ | 0.55 |
| Prior art 2 | ◯ | ✕ | $5 \times 10^{12}$ | 0.08 |
| Prior art 3 | ◯ | ✕ | $8 \times 10^{9}$ | 0.15 |

The characteristic tests were made in the following manner.

(1) Die-cutting work process (DCW)

The materials were punched by ASTM process and the finished condition of holes and peripheries thereof were assessed. In the result, "◯" indicates a good result, "△" indicates that some naps or fins remained uncut and "✕" indicates many fiber naps remained uncut.

(2) 180 degree repeated bending characteristic (RBC)

This test was made by repeatedly bending by 180 degree the test pieces obtained by cutting the materials by a size of 20 x 100 mm in a lateral direction in which they were lower in their strength. The bending tests were made by counting a number of times within the limit of 10 times until at the bended portion occurs such a crack as hindering the use in practice. In the result, "✕" indicates that the pieces were broken by only one time of bending.

(3) Insulation resistance (IR)

This was measured by JIS-C-6481 process.

(4) Size shrinkage ratio (SSR)

This test was made by removing copper foils out of the test pieces obtained by cutting the materials by a size of 20 x 300 mm and measuring the longitudinal and lateral sizes before and after the test pieces were thermally processed in an oven of 150 °C for 30 minutes. The size shrinkage ratio was obtained from the maximum value of size shrinkage ratio measured by the following expression.

Size shrinkage ratio (%) = (Size before thermal process - size after thermal process)x 100/size before thermal process

Examples 3 to 5

30 weight parts of acrylonitrile/butadiene copolymer having carboxyl groups at both ends, 40 weight parts of nonflammable epoxy resin (epoxy equivalent of 400 and bromine inclusion ratio of 48 %, tradename, YDB-400, manufactured by Tohto Kasei Company, Japan), 20 weight parts of epoxy resin (epoxy equivalent of 195, tradename of EP-828 manufactured by Yuka Shell Company, Japan) and 10 weight parts of cresol novolak epoxy resin (epoxy equivalent of 210, tradename YDCN-704,manufactured by Tohto Kasei Company, Japan) were reacted with each other under catalyst of triphenyl phosphine at a temperature of 180 °C for 4 hours. This reactant was blended with curing agent of dicyandiamide to prepare varnish.

There was prepared base material of woven cloth of meta-aramid fiber and polyethylene terephthalate fiber combined in the form of threads with the ratio of warp to woof of 12/11. In Examples 3, 4 and 5, the ratios of meta aramid fiber were 10 weight %, 40 weight % and 70 weight %, respectively. A prepreg was prepared by impregnating the respective base materials of woven cloth with the aforementioned varnish so that the resin was contained by 60 % and drying it. Copper foils having a thickness of 35 μm were faced with both faces of the prepreg and subject to a pressure of 30 kg/cm² at a temperature of 170 °C for 30 minutes to provide a both face copper foil covered laminate of thickness of 0.6 mm.

Example 6

There was prepared a base of woven cloth formed of meta-aramid fiber thread and polyethylene terephthalate fiber thraed while the diameter and number of threads were so adjusted that the ratio of meta-aramid fiber is 40 weight %. A both face copper foil covered laminate of 0.6 mm thickness was produced by using the aforementioned base in the same manner as described with reference to Example 3.

Comparison 5

90 weight parts of nonflammable epoxy resin (epoxy equivalent of 500 and bromine inclusion ratio of 22 %, tradename of ESB-500 manufactured by Tohto Kasei Company, Japan), 10 weight parts of YDCN-704 and 3 weight parts of curing agent of dicyandiamide were blended to prepare varinsh. The woven fiber base of Example 4 was impregnated with the resultant varnish to obtain a prepreg. From the prepreg was produced a both face copper foil covered laminate of 0.6 mm thickness in the same manner as described on Example 4.

Table II indicates the result of characteristic tests of the laminates of Examples 3 to 6, Comparison 5 together with that of Prior art 1. In the table, "DCW" and "SSR" designate the same as in TAble I while "BAF" designates blend ratio (%) of aramid fiber, "BC" designates a bending characteristic (mm) and "TS" designates tensile strength (kg/mm²).

## TABLE II

|  | DCW | BAF | BC | TS | SSR (%) |
|---|---|---|---|---|---|
| Example 3 | ○ | 10 | 2.5 | 23 | 0.25 |
| Example 4 | ○ | 40 | 2.8 | 28 | 0.20 |
| Example 5 | △ | 70 | 2.9 | 30 | 0.17 |
| Example 6 | ○ | 40 | 2.8 | 28 | 0.20 |
| Comparison 5 | ○ | 40 | 10.5 | 29 | 0.36 |
| Prior art 1 | △ | – | freely bent | 3 | 0.55 |

In the table II, the test of bending characteristic was made by measuring the minimum bending radius of the laminates at which the laminates were neither broken nor cracked. The tensile strength was measured by JIS-C-6481. The other tests were made in the same manner as described on Table I.

In Examples 7 and 8, there were used a sheet-like base of meta-aramid fiber and glass fiber. The blend ratio of meta-aramid fiber to glass fiber is not defined specifically, since as the amount of glass fiber increases, the size shrinkage will be much prevented, but the blending characteristic will be deteriorated. Thus, it should be noted that the ratio of them should be set at a suitable value.

Example 7

A base of meta-aramid fiber and E glass fiber having a fiber diameter of 9 μ and a length of 25 mm combined in the form of nonwoven cloth so that the weight ratio of meta-aramid fiber to E glass fiber was 2/1 was impregnated with the resin varnish used in Example 1 and dried to produce a prepreg in the same manner as described in Example 1. Copper foils having a thickness of 35 μm were faced with both faces of the prepreg and subject to a pressure of 30 kg/cm² at a temperature of 170°C for 30 minutes to provide a both face copper foil covered laminate of thickness of 0.2 mm.

Example 8

There was prepared a base of nonwoven cloth formed of meta-aramid fiber and E glass fiber admixed so that the weight ratio of meta-aramid fiber to E glass fiber was 1/2 and a both face copper foil covered laminate of 0.2 mm thickness was produced by using the base in the same manner as described in Example 7.

7

Comparison 6

To an epoxy resin (Tradename of EP-1001 manufactured by Yuka Shell Company, Japan) was added curing agent of dicyandiamide so that it was included by 4 weight % to obtain a resin varnish. The nonwoven fiber base of Example 7 was impregnated with the resultant resin varnish so that the resin was included by 80 weight % and dried to obtain a prepreg. Copper foils of 35 μm were faced with the prepreg and subject to the pressure in the same manner as described on Example 7 to obtain a both face copper foil covered laminate of 0.2 mm thickness.

Comparison 7

There was prepared a base of nonwoven cloth formed of para-aramid fiber and E glass fiber in combination so that the weight ratio of para-aramid fiber to E glass fiber was 1/2 and a both face copper foil covered laminate of 0.2 mm thickness was produced by using the base in the same manner as described on Example 7.

A table III indicates the result of characteristic tests of the laminates of Examples 7 and 8 and Comparisons 6 and 7 together with those of Prior arts 1 through 3. In the table, "DCW", "IR" and "SSR" designate the same as in Table I while "180BC" designates the characteristic of bending by 180 degree and "TR" (second) designates thermal resistance to soft solder at 260 °C (D-2/100).

## TABLE III

| | DCW | 180BC | TR | IR | SSR (%) |
|---|---|---|---|---|---|
| Example 7 | O | O | 40 to 60 | $8 \times 10^{12}$ | 0.12 |
| Example 8 | O | O~△ | 40 to 60 | $8 \times 10^{12}$ | 0.11 |
| Comparison 6 | O | × | 40 to 60 | $7 \times 10^{12}$ | 0.11 |
| Comparison 7 | × | O | 10 to | $2 \times 10^{8}$ | 0.12 |
| Prior art 1 | △ | O | 5 | $2 \times 10^{12}$ | 0.55 |
| Prior art 2 | O | × | 40 to 60 | $5 \times 10^{12}$ | 0.08 |
| Prior art 3 | O | × | 15 | $8 \times 10^{9}$ | 0.15 |

In the table III, the test of characteristic of bending by 180 degree was made by assessing cracks in the test pieces obtained by cutting the materials by a size of 20 x 100 mm when they are bent by 80 degree. In the test of 180BC, "○" indicates that there was no crack, "△" indicates that there was such a fine crack as causes no problem in practice and "X " indicates that the test pieces were broken and could not be practically used. The test of thermal resistance to soft solder was made by JIS-C-6481. The other tests were made in the same manner as described on Table I.

In Examples 9 to 11, there were used a sheet-like base of threads of combination of glass fiber and polyethylene terephthalate fiber. The blend ratio of meta-aramid fiber to glass fiber is not defined specifically, but in case of the blend ratio of glass fiber being 10 weight %, the better result was obtained. As the blend ratio of glass fiber increases, the bending characteristic is lowered, but the size stability is improved.

Examples 9 to 11

There was prepared base material of woven cloth of glass fiber and polyethylene terephthalate fiber combined in the form of threads with the ratio of warp to woof of 4/3. In Examples 9, 10 and 11, the ratios of glass fiber were 5 weight %, 10 weight % and 30 weight %, respectively. A prepreg was prepared by impregnating the respective base materials of woven cloth with the varnish used in Example 3 so that the resin was contained by 60% and drying it. A both face copper foil covered laminate of thickness of 0.6 mm was produced in the same manner as described on Example 3.

Example 12

There was prepared a base of woven cloth formed of glass fiber thread and polyethylene terephthalate fiber thraed while a diameter and a number of threads were so adjusted that the ratio of glass fiber was 10 weight %. A both face copper foil covered laminate of 0.6 mm thickness was produced by using the aforementioned base in the same manner as described with reference to Example 9.

Example 13

By using a base of nonwoven cloth formed of glass fiber and polyethylene terephthalate fiber combined so that the ratio of glass fiber was 10 weight % was produced a both face copper foil laminate of 0.6 mm thickness in the same manner as described on Example 9.

Comparison 8

By impregnating the woven cloth of Example 10 with the varnish of Comparison 5 was produced a both face copper film covered laminate of 0.6 mm thickness.

Table IV indicates the result of characteristic tests of the laminates of Examples 9 through 13 and Comparison 8 together with that of Prior art 1. In the table, "BC", "SSR" and "TS" designate the same as in Table II while "BRG" designates blend ratio (%) of glass fiber.

9

## TABLE IV

|  | BRG | BC | SSR (%) | TS |
|---|---|---|---|---|
| Example 9 | 5 | 3.5 | 0.45 | 25 |
| Example 10 | 10 | 4.0 | 0.25 | 28 |
| Example 11 | 30 | 6.5 | 0.20 | 30 |
| Example 12 | 10 | 4.0 | 0.25 | 28 |
| Example 13 | 10 | 4.0 | 0.28 | 10 |
| Comparison 8 | 10 | 15.5 | 0.23 | 29 |
| Prior art 1 | – | freely bent | 0.55 | 3 |

## Claims

1. A metal laminate covered with foil, comprising; a sheet-like base formed of a mixture of at least two of meta-aramid fiber, polyethylene terephthalate fiber and glass fiber and impregnated with an adduct of epoxy resin and an acrylonitrile/butadiene copolymer having carboxyl groups at its terminals; and

a metal foil covering at least one face of said base.

2. A laminate as claimed in Claim 1, wherein said mixture of fibers is of meta-aramid fiber and polyethylene terephthalate fiber.

3. A laminate as claimed in Claim 1, wherein said mixture of fibers is of meta-aramid fiber and glass fiber.

4. A laminate as claimed in Claim 1, wherein said mixture of fibers is of glass fiber and polyethylene terephthalate fiber.

5. A laminate as claimed in any of Claims 1 to 4, wherein said sheet-like base is in the form of nonwoven fabric.

6. A laminate as claimed in any of Claims 1 to 4, wherein said sheet-like base is in the form of woven fabric.

7. A laminate as claimed in any preceding claim, wherein said epoxy resin adduct is a product of the preliminary reaction of acrylonitrile/butadiene copolymer having terminal carboxyl groups and epoxy resin.

8. A laminate as claimed in any preceding claim wherein curing agent is included in the impregnated base.

9. A printed circuit board comprising a laminate as claimed in any preceding claim.